# EUROPÄISCHE PATENTSCHRIFT

(11) **EP 0 970 773 B1**
(45) Veröffentlichungstag und Bekanntmachung des Hinweises auf die Patenterteilung: **30.06.2004**
(21) Anmeldenummer: 99102012.4
(22) Anmeldetag: 01.02.1999
(51) Int. Cl.: B23K 3/08, H05K 13/00, B23K 37/04

(54) **Warenträger mit einstellbaren Unterstützungselementen und Reflow-Lötanlage mit derartigem Warenträger**
Merchandise carrier with adjustable support elements and reflow-soldering device including a such carrier
Porte-marchandises à éléments de support réglables et appareil de soudage par refusion avec un tel porte-marchandises

(30) Priorität: 15.06.1998 DE 29810695 U
(43) Veröffentlichungstag der Anmeldung: 12.01.2000
(73) Patentinhaber: Rehm Anlagenbau GmbH, 89143 Blaubeuren-Seissen (DE)
(72) Erfinder: Rehm, Johannes, 89601 Schelklingen (DE)
(74) Vertreter: Grünecker, Kinkeldey, Stockmair & Schwanhäusser Anwaltssozietät

(56) Entgegenhaltungen:
- FR-A- 2 625 402
- US-A- 3 930 644
- US-A- 4 030 717
- US-A- 4 657 146
- US-A- 5 067 648
- US-A- 5 438 740
- US-A- 5 595 410

## Beschreibung

Die vorliegende Erfindung betrifft einen Warenträger mit einstellbaren Unterstützungselementen gemäß Oberbegriff des Patentanspruchs 1. Weiter betrifft die Erfindung eine Reflow-Lötanlage zur Durchführung eines Reflow-Lötprozesses an mit elektronischen Bauteilen versehenen Leiterplatten mit einem solchen Warenträger.

Reflow-Lötanlagen, mit denen auf Leiterplatten vormontierte elektronische Bauelemente mit einem Verdrahtungsschema auf der Leiterplatte unter Hitzeeinwirkung verlötet und damit elektrisch verbunden werden, sind im Stand der Technik allgemein bekannt. Bei derartigen Reflow-Lötanlagen müssen die Waren, d.h. die Leiterplatten, durch eine relativ lange Anlage mit unterschiedlichen Zonen, nämlich einer Vorheizzone, einer Hauptheizzone, einer Abkühlzone und einem Ausgabebereich, transportiert werden. Die Leiterplatten werden dabei auf einem Warenträger mittels eines Transportmechanismus, wie z.B. einer von der Anlage angetriebenen Förderkette oder eines Gliederbands, durch diese Zonen bewegt.

Eine derartige Reflow-Lötanlage stellt eine sehr investitionsintensive Anschaffung dar. Es ist daher selbstverständlich erforderlich, daß eine solche Anlage für mehr als ein bestimmtes Leiterplattenformat geeignet ist. Um Leiterplatten verschiedener Größe in einer solchen Reflow-Lötanlage zu behandeln, wurde bisher jeweils der Warenträger durch einen an das gerade zu bearbeitende Leiterplattenformat passenden Warenträger ausgetauscht. Dies machte es einerseits erforderlich, einen relativ großen Vorrat an geeigneten Warenträgem für die jeweils zu verarbeitenden Leiterplattenformate bereitzustellen, andererseits waren bei Umstellung von einem Leiterplattenformat auf ein neues Format umständliche und langwierige Eingriffe durch eine Bedienungsperson für den Austausch der Warenträger erforderlich.

Auch bei Bevorratung vieler verschiedener Warenträger konnten nur Standardleiterplattenformate, an die die Warenträger angepaßt waren, bearbeitet werden. Leiterplatten in Spezialanfertigung waren nicht durch eine derartige Reflow-Lötanlage schleußbar. Zur Behebung dieses Problems mußten die Warenträger individuell von Hand durch eine Bedienperson umgebaut oder angepaßt werden.

Jegliche Eingriffe des Bedieners in den Betrieb einer Reflow-Lötanlage führen jedoch zu einer drastischen Verringerung der Effizienz des Durchsatzes durch die Anlage, was in Verbindung mit den hohen Anschaffungskosten einer Reflow-Lötanlage zu einem bedeutenden Kostenproblem wird.

**US 4,030,717** zeigt einen Warenträger für insbesondere bedruckte Leiterplatten gemäß dem Obergegriff des Anspruchs 1. Der Warenträger weist ein Rahmengestell auf, das mehrere Elemente umfasst, die zur Anpassung an unterschiedliche Größen der Leiterplatten einstellbar sind. Zur Fixierung der beispielsweise schienenartigen Träger sind Schrauben vorgesehen. Die Träger sind separat zum eigentlichen Rahmen und einwärts versetzt zu entsprechenden Rahmenteilen angeordnet.

**US-A-5,067,648** zeigt einen weiteren Warenträger zum Halten bedruckter Leiterplatten. in einem Rahmengestell mit Rahmenteil sind Tragteile verschiebbar gelagert, wobei an diesen an deren Längsrichtung weitere Seitenteile verschiebbar gelagert sind. Außerdem ist noch zwischen den Seitenteilen und den Tragteilen ein Diagonalteil und ein Lateralteil angeordnet. An jedem dieser verschiebbaren Teile können eine Reihe von Montageklipsen verschiebbar und in entsprechender Position fixierbar gelagert sein.

**US-A-4,657,146** zeigt einen Warenträger für Leiterplatten, bei dem diese sowohl horizontal als auch nahezu vertikal angeordnet sein können. Eine Halteschiene dient zur Lagerung der Leiterplatten. Diese ist gegenüber dem restlichen Rahmengestell verstellbar entlang zweier Rahmenteile gelagert. Die Befestigung der Halteschiene erfolgt über Schrauben und entsprechende Spannbügel.

**FR 2 625 402 A1** zeigt einen Träger für zu verlötende Teile, wobei an einem Rahmengestell zwei Träger verschiebbar gelagert sind. Am unteren Ende der Träger ist eine Leiterplatte in entsprechenden Nuten anordbar.

**US-A-3,930,644** zeigt einen Warenträger für eine bedruckte Leiterplatte. Diese ist an Längsenden in verstellbar gelagerten Halterplatten in deren unteren Enden angeordneten Nuten gehalten. Die Platten sind entlang eines Stabes verstellbar. Der Stab wiederum ist quer verschieblich an weiteren Stangen gelagert.

**US-A-5,438,740** zeigt einen Warenträger mit einer Reihe von positionierbaren Halteelementen, die auf einer Lochplatte entsprechend positionierbar sind. Die Halteelemente dienen zum Halten einer Leiterplatte, wobei diese eine Öffnung zur Ausrichtung aufweist. Die Öffnung wird auf eine Spitze eines Stifts aufgelegt und dort wird die Leiterplatte mittels eines federbeaufschlagten Hakens gehalten.

Es ist daher die Aufgabe der vorliegenden Erfindung, einen Warenträger der eingangs genannten Art zu schaffen, mit dem eine einfache Verstellung des Warenträgers auf unterschiedliche, gegebenenfalls auch von einem Standardformat abweichende Leiterplattenformate möglich ist.

Weiter ist es die Aufgabe der vorliegenden Erfindung, eine Reflow-Lötanlage der eingangs genannten Art unter Verwendung eines derartigen Warenträgers zu schaffen, mit der eine Anpassung des Warenträgers an die Größe einer zu bearbeitende Leiterplatte maschinell durchführbar ist.

Erfindungsgemäß wird die erste Aufgabe gelöst durch einen Warenträger mit den Merkmalen nach Patentanspruch 1.

Durch die Arretierungsmittel ist es möglich, eine sichere und dauerhafte Fixierung des Auflagerelements retativ zu dem Rahmenteil zu schaffen. Ein bisher nach dem Stand der Technik notwendiger langwieriger Umbau des Warenträgers, der dann in den Fördermechanismus der Reflow-Lötanlage eingesetzt wurde, ist mit dem erfindungsgemäßen System nicht mehr nötig. Der Warenträger kann an Ort und Stelle im Transportsystem der Reflow-Lötanlage bleiben, wenn durch Lösen der Arretierung, Verschieben des Auflagerelements und erneute Arretierung die Anpassung an die gerade zu fördernde Platinengröße durchgeführt wird. Der erfindungsgemäße Warenträger besitzt den weiteren Vorteil, daß eine Anpassung maschinell, durch eine Reflow-Lötanlage vomehmbar ist. Die bisher notwendigen Stillstandszeiten der Maschine durch den Eingriff der Bedienungsperson zur Anpassung des Warenträgers an das Platinenformat fallen dadurch weg. Dies führt zu einer höheren Effizienz und einer insgesamt höheren Maschinenauslastung als dies nach dem Stand der Technik möglich war.

In einer vorteilhaften Weiterbildung gestatten die Arretierungsmittel eine stufenlose Feinabstimmung für die Einstellung der gegenseitigen Position des Auflagerelements und des Rahmenteils, an denen die Leiterplatten unterstützt werden.

In einer weiteren vorteilhaften Weiterbildung der Erfindung umfaßt das Arretierungssystem Klemmittel, mit denen die stufenlose Feineinstellung der Position des Auflagerelements relativ zu dem als weiteren Auflager wirkenden Rahmenteil möglich ist.

In einer weiteren vorteilhaften Weiterbildung ist die Klemmeinrichtung dadurch verwirklicht, daß die Klemmelemente wenigstens eine an einem Grundkörper angelenkte Klemmplatte mit einer Ausnehmung, die von einem Profil einer Schiene wenigstens teilweise durchdrungen wird, und jeweils Vorspannmittel umfassen, mit dem die am Grundkörper angelenkte(n) Klemmpfatte(n) bis zur Anlage im Bereich der Ausnehmung an dem Profil der Schiene ausgelenkt wird.

Dadurch wird eine außergewöhnlich einfache, jedoch mechanisch zuverlässige und exakt zu bedienende stufenlose Einstellung ermöglicht, die zu einer für die vorliegenden Zwecke außerordentlich zuverlässigen Fixierung des Auflagerelements führt. Insbesondere ist durch diese Ausgestaltung des Klemmelements ein sehr einfacher maschineller Einstellvorgang möglich, da lediglich die Klemmplatten entgegen der Vorspannkraft an den Grundkörper zur Entarretierung gedrückt werden müssen. Dies ist z.B. mittels eines einfachen Greifelements oder einer Gabel, die entlang der Klemmplatten bewegbar und in der Einstellrichtung verschiebbar in der Reflow-Lötanlage vorgesehen ist, zu realisieren. Diese Lösung ist mechanisch sehr einfach und weist daher einen hohen Kostenvorteil auf.

In einer weiteren vorteilhaften Ausführungsform besitzt der Warenträger eine höhenverstellbare Mittenunterstützung. Durch die Mittenunterstützung wird einerseits verhindert, daß bei den zur Durchführung des Reflow-Vorgangs notwendigen hohen Temperaturen eine Verformung der Platine durch ihre Schwerkraft auftritt, andererseits kann durch die Höhenverstellbarkeit eine genaue Anpassung an die Art der zu bearbeitenden Leiterplatte vorgenommen werden.

Die zweite oben genannte Aufgabe wird gelöst durch eine Reflow-Lötanlage der eingangs genannten Art, die sich auszeichnet durch eine Einstellvorrichtung zur Anpassung des einstellbaren Auflagerelements des Warenträgers an die Größe der aufzunehmenden Leiterplatten vorgesehen ist.

Durch die erfindungsgemäße Reflow-Lötanlage wird eine maschinelle, automatische Anpassung der Warenträger an die aktuell zu verarbeitende Leiterplattengröße geschaffen. Dadurch wird eine Stillstandszeit der Anlage aufgrund eines Eingriffs durch eine Bedienperson zur Einstellung der Warenträger minimiert und zugleich kann durch die maschinelle Vornahme des Einstellvorgangs die Anpassungsgenauigkeit erhöht werden.

In einer vorteilhaften Weiterbildung besitzt die erfindungsgemäße Reflow-Lötanlage auch eine Höheneinstelleinrichtung zur Anpassung der Höhenlage der Mittenunterstützung des Warenträgers. Durch die vollständig maschinelle Anpaßbarkeit des Warenträgers sowohl bezüglich der Größendimension der zu verarbeitenden Leiterplatten als auch bezüglich der Höhenlage der Mittenunterstützung wird die schnelle und zuverlässige Verarbeitung von Leiterplatten in der Reflow-Lötanlage gewährleistet. Dies führt zu einer Erhöhung der Effizienz und einer Verbesserung des Anlagendurchsatzes und letztendlich zu einem Kostenvorteil beim Betrieb und Unterhalt der Anlage.

Weitere vorteilhafte Ausführungsformen sind in den abhängigen Patentansprüchen bezeichnet.

Nachfolgend wird die vorliegende Erfindung beispielhaft anhand eines Ausführungsbeispiels in bezug auf die beiliegenden Zeichnungen näher erläutert und beschrieben.

In den Zeichnungen zeigen:
- Fig. 1: eine Draufsicht auf einen erfindungsgemäßen Warenträger;
- Fig. 2: eine Draufsicht auf ein erfindungsgemäßes Arretierungsmittel im Detail;
- Fig. 3: eine Seitenansicht des in der Fig. 2 gezeigten Arretierungsmittels;
- Fig. 4: eine Seitenansicht einer erfindungsgemäßen höhenverstellbaren Mittenunterstützung;
- Fig. 5: eine Draufsicht auf die in Fig. 4 gezeigte höhenverstellbare Mittenunterstützung; und
- Fig. 6: eine Querschnittsansicht des erfindungsgemäßen Warenträgers, die entlang der Linie VI-VI der Fig. 1 genommen wurde.

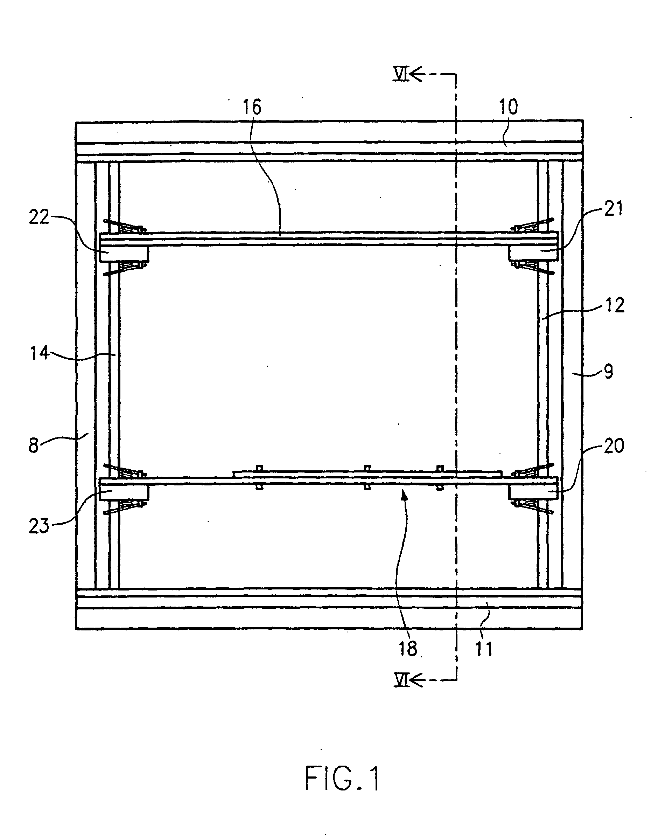

Die Fig. 1 zeigt einen erfindungsgemäßen Warenträger in der Draufsicht. Der Warenträger umfaßt ein äußeres Rahmengestell, das aus vier, im wesentlichen rechtwinklig zusammengefügten Rahmenteilen 8, 9, 10 und 11 besteht Zwischen den zwei paraltelen Rahmenteilen 10 und 11 sind im wesentlichen senkrecht dazu zwei Schienen 12 und 14 in der Nähe der seitlichen Rahmenteile 8 und 9 angebracht. An den Schienen sind jeweils über Arretierungselemente 21 und 22 ein Auflagerelement 16 und über Arretierungselemente 20 und 23 eine höhenverstellbare Mittenunterstützung 18 angebracht. Mittels der an den Schienen 12 und 14 vorgesehenen Arretierungselemente 20, 21, 22 und 23 sind die Mittenunterstützung 18 und das Auflagerelement 16 lösbar arretierbar befestigt und somit bei Lösung der Arretierung entlang der Richtung der Schienen verschiebbar.

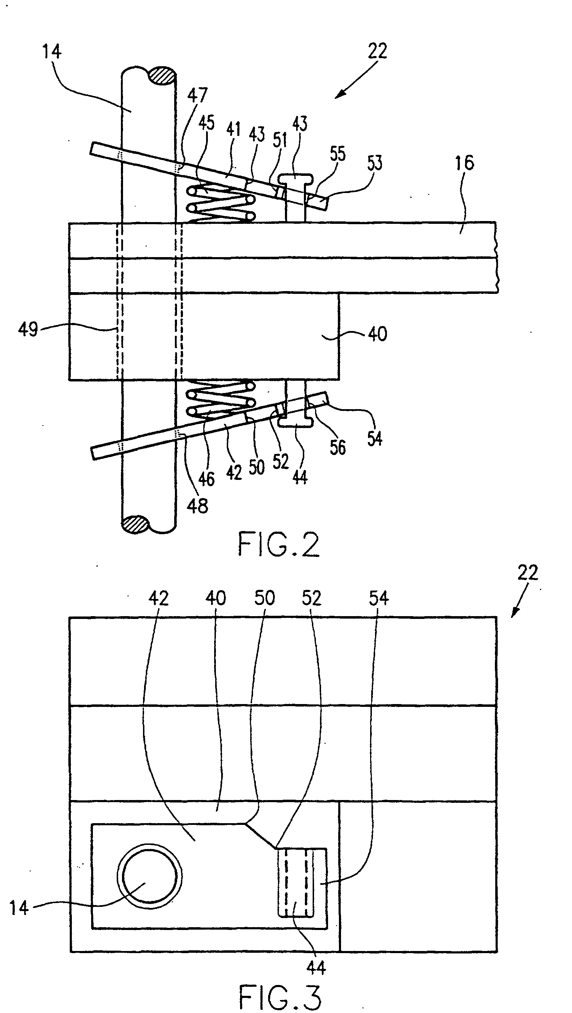

Fig. 2 zeigt eine Draufsicht auf das Arretierungselement 22 in vergrößerter Darstellung. An dem Auflagerlagerelement 16 ist ein Grundkörper 40 befestigt, der eine Bohrung 49 aufweist, durch die die im wesentlichen rundstabförmige Schiene 14 sich erstreckt. An dem Grundkörper 40 sind jeweils zu beiden Seiten Klemmplatten 41 und 42 vorgesehen, die jeweils an ihrem von der Schiene 14 abgewandten Ende gelenkig mit dem Grundkörper 40 verbunden sind. Die gelenkige Verbindung mit dem Grundkörper 40 umfaßt zu beiden Seiten des Grundkörpers 40 abstehende Poller 43 und 44. Die Klemmplatten 41 und 42 weisen im Bereich der gelenkigen Verbindung Ausnehmungen 55 und 56 auf, die die Poller 43 und 44 zwischen dem aufgeweiteten Ende und dem Grundkörper umgreifen. Die Ausnehmungen 55 und 56 sind so dimensioniert, daß ausreichend Spiel vorhanden ist, die Klemmplatten 41 und 42 über einen großen Winkelbereich zu bewegen, ohne die Anlenkverbindung aufzubrechen. Weiter sind zwischen dem Grundkörper 40 und den Klemmplatten 41 und 42 jeweils Federn 45 und 46 vorhanden, die sich zwischen dem Grundkörper 40 und jeweils einem mittleren Bereich der entsprechenden Klemmplatte abstützen. Durch die Federn 45 und 46 werden die Klemmplatten 41 und 42 in eine gegenüber der parallelen Anlageposition an dem Grundkörper 40 ausgelenkte Position vorgespannt. Die Klemmplatten 41 und 42 weisen weiter im Bereich der Schiene 14 eine Ausnehmung 47 auf, die im wesentlichen zur Querschnittsform der Schiene 14 komplementär und geringfügig größer als diese ausgebildet ist. Die Größen der Ausnehmungen 47 und 48 in Verbindung mit der Bohrung 49 und der Querschnittsform und Größe der Schiene 14 sind einander so angepaßt, daß durch die Vorspannung der Klemmplatten 41 und 42 gegenüber dem Grundkörper 40 durch die Federn 45 und 46 die jeweiligen Klemmplatten im Bereich ihrer Ausnehmung an der Schiene zur Anlage kommen und die Schiene einerseits entweder in der Ausnehmung 47 bzw. 48 verklemmen, oder die Schiene gegen die Innenwand der Bohrung 49 klemmen.

Zur Entarretierung werden die Klemmplatten 41 und 42 entgegen der Vorspannung durch die Feder in eine Lage, die im wesentlichen senkrecht ist zur Länge der Schienen 14, gebracht, d.h. sie werden an die Seitenflächen des Grundkörpers 40 gedrückt. Die Entarretierung kann vorteilhafterweise durch einen zangenförmigen Greifer auf maschinelle Weise erfolgen. Bei zusammengedrückten, d.h. entarretierten Klemmplatten 41 und 42 durch einen solchen Zangengreifer kann durch Verschiebung des Zangengreifers zusammen mit dem Arretierungselement 22 das Auflagerelement 16 entlang der Schiene 14 verschoben werden.

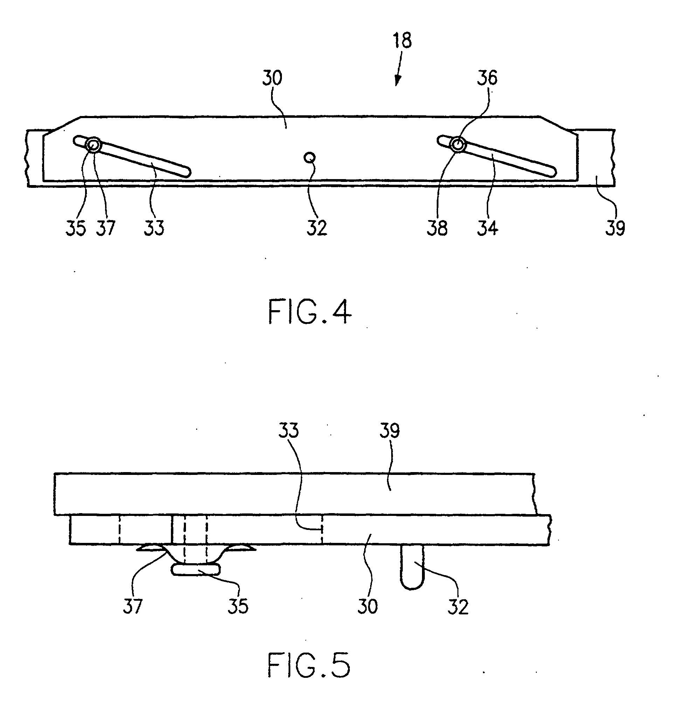

Die Fig. 3 zeigt eine Seitenansicht des in Fig. 2 gezeigten Arretierungselements 22. Die Seitenansicht des Arretierungselements 22 verdeutlicht die Ausgestaltung der Klemmplatte 42, insbesondere die Art und Weise, wie die gelenkige Verbindung mit dem Grundkörper 40 gebildet ist. Die Klemmplatte 42 verjüngt sich in Richtung der gelenkigen Verbindung hin an ihrer oberen Seitenkante, wobei ihre Breite im Bereich zwischen zwei Knickstellen 50 und 52 der Seitenlinie abnimmt. In einem Endbereich 54 der Klemmplatte ist eine U-förmige Ausnehmung vorgesehen, in die ein, der U-förmigen Ausnehmung entsprechend ausgebildeter, in seinem Querschnitt länglicher Poller 44, der mit dem Grundkörper 40 in fester Verbindung steht, eingreift.

Weder die Gestalt der Klemmplatte 42 noch die Verwirklichung der gelenkigen Verbindung sind auf die hier beschriebene Ausführungsform beschränkt. Statt dessen kann die Klemmplatte an ihrem anderen Ende und gegebenenfalls unter Verlängerung ihres über die Schiene 14 hinausreichenden Endes, angelenkt sein. Die Platte kann jede beliebige Form haben und ist nicht auf die hier genau gezeigte, sich zum Anlenkpunkt verjüngende Form beschränkt. Während die hier gezeigte gelenkige Verbindung sich durch besondere Einfachheit und leichte Herstellbarkeit auszeichnet, wäre es auch denkbar, eine Schamierverbindung oder andere Arten einer Verbindung zu verwenden.

Ganz allgemein kann die Klemmwirkung nicht nur durch ein in den Figuren 2 und 3 gezeigtes Arretierungselement, sondem auch durch beispielsweise eine Schiene mit Expansionsmitteln erzielt werden. Die Schiene ist andererseits nicht auf die hier gezeigte Rundstabform beschränkt, sondem kann jede Art von Profil, z.B. ein T-Profil etc. aufweisen.

Die Fig. 4 zeigt eine Draufsicht auf einen Mittenbereich der höhenverstellbaren Mittenunterstützung 18. An einem Träger 39, der an beiden Enden jeweils mit einem in den Figuren 2 und 3 gezeigten Arretierungselement in Verbindung steht, ist eine Schieberplatte 30 zur Höheneinstellung angebracht. Die Schieberplatte 30 weist zwei zueinander parallele, auf gleicher Höhe und seitlich versetzt zueinander angeordnete, relativ zur Richtung des Trägers 39 einen Winkel von mehr als 0° und weniger als 180° bildende längliche Kulissenschlitze 33 und 34 auf. Durch diese Kulissenschlitze ragen zwei jeweils auf gleicher Höhe an dem Träger 39 befestigte Stifte 35 und 36. Die Enden der Stifte, die entweder verschraubt oder anderweitig aufgeweitet sind, haltern jeweils Tellerfedern 37 und 38, die die Schieberplatte 30 gegen den Träger 39 vorspannen und pressen. An der Schieberplatte 30 ist ein seitlich vorspringender Stift 32, der als Betätigungselement oder Griff dient, angebracht

Durch die Vorspannung der Tellerfeder 37 und 38 ist die Schieberplatte 30 durch die zwischen den beiden Elementen wirkende Reibung in ihrer Lage stabil. Erst bei Anwendung einer eine Schwelle überschreitenden Kraft kann die Schieberplatte 30 gegenüber dem Träger 39 verschoben werden, wobei durch die Kulissenschlitze 33 und 34 eine Zwangsführung gebildet wird. Bei Anwendung einer parallel zum Träger 39 wirkenden Kraft wird durch die Neigung der Kulissenschlitze 34 und 35 relativ zur Längsrichtung des Trägers 39 die Schieberplatte 30 nicht nur in ihrer seitlichen, sondem auch in ihrer Höhenlage bezüglich des Trägers 39 verschoben.

Die hier gezeigte Form für die Höheneinstellung gibt lediglich eine aufgrund ihrer mechanisch einfachen Gestalt bevorzugte Ausführung wieder. Insbesondere ist diese Art der Höhenverstellung bevorzugt für eine maschinenautomatische Einstellung geeignet, da ein an der Reflow-Lötanlage vorhandener gabelförmiger Greifer mit dem Stift 32 an der Schieberplatte 30 in Eingriff gebracht werden muß, und anschließend nur in einer Richtung verschoben werden muß, um zugleich die Höheneinstellung der Mittenunterstützung zu schaffen. Da die Neigung der Kulissenschlitze 33 und 34 relativ zur Richtung des Trägers 39 bekannt ist, kann die Höheneinstellung auch quantitativ durch Einstellung des Verfahrwegs des Greifers entlang der Richtung des Trägers 39 genau bestimmt werden.

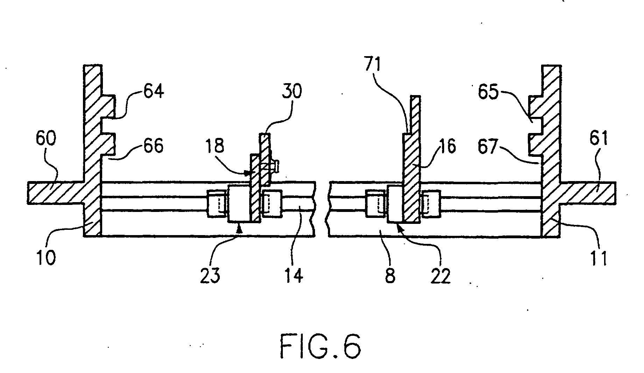

In der Fig. 5 ist die in Fig. 4 in Seitenansicht gezeigte höhenverstellbare Mittenunterstützung nochmals in Draufsicht gezeigt. Es ist hier insbesondere deutlich zu sehen, wie sich die Tellerfeder zwischen dem pollerförmig verbreiterten Ende des durch den Kulissenschlitz 33 ragenden Stifts 35 und der Schieberplatte abstützt.

In Fig. 6 ist eine Querschnittsansicht entlang der Linie VI-VI in der Fig. 1 gezeigt. Gemäß der hier gezeigten Ausführungsform haben die Rahmenteile 10 und 11 jeweils ein Profil mit nach innen ragenden Leisten 64 und 66 bzw. 65 und 67, an dem die Leiterplatten aufliegen können. Das Auflagerelement 16 besitzt einen der Höhe der Leiste 64 entsprechenden Sims 71, der ebenfalls als Unterstützung für eine zu tragende Leiterplatte dient. Zwischen dem linken Rahmenteil 10 und dem Auflagerelement 16 ist die höhenverstellbare Mittenunterstützung 18 gezeigt. Die Rahmenteile besitzen weiterhin nach außen vorstehende Flansche 60 und 61, an denen sich die Warenträger an einem entsprechenden, fest mit dem Fördersystem der Reflow-Lötanlage vorhandenen Förderrahmen abstützen.

Selbstverständlich kann die genaue Form der Profile der Rahmenteile an die Erfordemisse der zu fördernden Waren bzw. Leiterplatten angepaßt sein und von der in der Fig. 6 beispielhaft gezeigten Form abweichen.

Die erfindungsgemäße Reflow-Lötanlage, die in den Zeichnung nicht näher bezeichnet ist, besitzt einfache mechanische Zangengreifer, die z.B. durch Spindelantriebe verschwenkbar und linear bewegbar sind. Insbesondere besitzen die Greifer der Reflow-Maschine die Gestalt fester U-förmiger Gabeln, deren vordere Abstandsbreite so dimensioniert ist, daß das Arretierungselement über die Breite des Grundkörpers 40 einschließlich der Höhe der vorstehenden Poller 43 und 44 genau dazwischen Platz findet. Bei Verschwenken oder Verschieben der U-förmigen Gabeln entlang der Klemmplatten 41 und 42 in Richtung auf die Schienen zu, werden die Klemmplatten entgegen der Vorspannkraft der Federn an den Grundkörper 40 gedrückt, wodurch die Klemmwirkung aufgehoben und die Arretierung gelöst wird. Nachdem diese Gabein in die die Arretierung lösende Position gebracht worden sind, können die Greifer z.B. durch Spindelantriebe in Richtung entlang der Schienen verschoben werden, wodurch die Position des Auflagerelements relativ zu dem Rahmenteil 11 verschoben wird. Durch Zurückschwenken oder Zurückziehen der gabelförmigen Greifer wird die Klemmwirkung wieder hergestellt und die Arretierung wieder erzeugt.

Auf ähnliche Weise kann ein gabelförmiger Greifer in den Stift 32 der höhenverstellbaren Mittenunterstützung eingreifen und durch Linearverschiebung entlang der Richtung des Trägers 38 die Höheneinstellplatte 30 verschieben, die sich dabei aufgrund der schräggestellten Kulissenschlitze sowohl in seitlicher als auch in Höhenrichtung bewegt.

## Patentansprüche

1. Warenträger mit einstellbaren Unterstützungselementen zur Aufnahme von Waren unterschiedlicher Größe, insbesondere zur Halterung von Leiterplatten unterschiedlicher Größe beim Transport durch eine Reflow-Lötanlage, mit einem Rahmengestell (8, 9, 10, 11 ), wobei insbesondere ein Rahmenteil des Rahmengestells als ein Auflager für eine zu tragende Ware dient, und
wenigstens einem weiteren, bezüglich des Rahmenteils (11) einstellbaren Auflageelement (16), wobei
Arretierungsmittel (21, 22) vorgesehen sind, mit denen das Auflagerelement (16) bezüglich des Rahmenteils (11) arretierbar ist,
**dadurch gekennzeichnet,**
**dass** die Arretierungsmittel (21, 22) lösbar entlang von wenigstens zwei in Einstellrichtung des Auflagerelements (16) verlaufende Schienen umfassenden Führungsmitteln (12, 14), entlang deren das Auflagerelement (16) verschiebbar ist, arretierbar sind, wobei die Schienen jeweils parallel einwärts versetzt zu einem Rahmenteil (8, 9) am Rahmengestell fixiert sind und sich durch Bohrungen (49) in den Arretierungsmitteln (21, 22) zu deren stufenloser Verstellung entlang der Schienen erstrecken.

2. Warenträger gemäß Anspruch 1, **dadurch gekennzeichnet, daß** die Arretierungsmittel wenigstens eine an einem Grundkörper (40) angelenkte Klemmplatte (41, 42) mit einer Ausnehmung (47), die von einem Profil der Schiene (14) wenigstens teilweise durchdrungen wird, und jeweils Vorspannmittel (45, 46) umfassen, mit dem die am Grundkörper (40) angelenkte(n) Klemmplatte(n) bis zur Anlage im Bereich der Ausnehmung (47) an dem Profil der Schiene (14) ausgelenkt wird.

3. Warenträger gemäß Anspruch 2, **dadurch gekennzeichnet, daß** das Vorspannmittel (45, 46) eine sich zwischen der Klemmplatte (41, 42) und dem Grundkörper (40) abstützende Feder ist.

4. Warenträger gemäß einem der vorhergehenden Ansprüche, **dadurch gekennzeichnet, daß** zwischen dem Rahmenteil (11) und dem Auflagerelement (16) eine einstellbare Mittenunterstützung (18) mit Arretierungsmitteln (20, 23) vorgesehen ist.

5. Warenträger gemäß Anspruch 4, **dadurch gekennzeichnet, daß** die Mittenunterstützung eine Höhenverstellung (30) aufweist, die in einer Höhenrichtung, die zu der durch das Auflager des Rahmenteils (11) und des Auflagerelements (16) bestimmte Ebene senkrecht ist, einstellbar ist.

6. Warenträger gemäß Anspruch 5, **dadurch gekennzeichnet, daß** die Höhenverstellung eine an einem Trägerelement (39) angebrachte Schieberplatte (30) umfaßt, die mit Führungsmitteln versehen sind, entlang denen die Schieberplatte in einer, eine Komponente in der Höhenrichtung aufweisenden Richtung verschiebbar ist.

7. Warenträger gemäß Anspruch 6, **dadurch gekennzeichnet, daß** die Führungsmittel (33, 34) zwei, in der Längsdimension des Trägerelements (39) beabstandete und dazu jeweils einen Winkel einschließende Kulissen umfassen, über die die Schieberplatte und der Träger zusammenwirken, so daß bei Verschiebung der Schieberplatte (30) in einer Richtung entlang des Trägeretements (39) sich die Schieberplatte zwangsweise in der Höhenrichtung senkrecht zur Längsdimension des Trägerelements (39) bewegt.

8. Warenträger gemäß Anspruch 7, **dadurch gekennzeichnet, daß** die Kulissen entweder in der Schieberplatte oder in dem Trägerelement ausgebildet sind, und daß im jeweils anderen Teil die Kulissen durchdringende Zapfen (35, 36) vorgesehen sind.

9. Warenträger gemäß Anspruch 8, **dadurch gekennzeichnet, daß** die Zapfen mit Vorspannmitteln (37, 38) versehen sind, die die Schieberplatte gegen das Trägerelement (39) pressen.

10. Warenträger gemäß Anspruch 9, **dadurch gekennzeichnet, daß** die Vorspannmittel (37, 38) Tellerfedem sind.

11. Warenträger gemäß Anspruch 4-10, **dadurch gekennzeichnet, daß** ein Betätigungselement (32) zur Höheneinstellung vorgesehen ist.

12. Warenträger gemäß einem der vorhergehenden Ansprüche, **dadurch gekennzeichnet, daß** wenigstens das als Auflager wirkende Rahmenteil (11) ein Profil (64, 66) zur Lagerung der Waren in unterschiedlichen Höhen aufweist.

13. Reflow-Lötanlage zur Durchführung eines Reflow-Lötprozesses an mit elektronischen Bauteilen versehenen Leiterplatten umfassend einen Warenträger gemäß einem der vorhergehenden Ansprüche und eine Einstellvorrichtung zur Anpassung des einstellbaren Auflagerelements des Warenträgers an die Größe der aufzunehmenden Leiterplatten, vorgesehen ist.

14. Reflow-Lötanlage gemäß Anspruch 13, **dadurch gekennzeichnet, daß** die Einstellvorrichtung in einer Richtung, entlang der die Position des Auflagerelements zu verändern ist, verschiebbare Entarretierungsmittel aufweist.

15. Reflow-Lötanlage gemäß Anspruch 13, **dadurch gekennzeichnet, daß** die Entarretierungsmittel Greifelemente aufweisen, mit denen die Klemmplatten der Arretierungsmittel des Warenträgers gegen den Grundkörper entgegen der Vorspannungskraft bewegbar sind zum Lösen einer Verspannung der Klemmplatten mit dem Profil der Schiene.

16. Reflow-Lötanlage gemäß einem der Ansprüche 13-15, weiter **gekennzeichnet durch** ein Höheneinstellmittel zur Einstellung einer Höhe der Mittenunterstützung des Warenträgers.

17. Reflow-Lötantage gemäß Anspruch 16, **dadurch gekennzeichnet, daß** das Höheneinstellmittel einen Greifer umfaßt, mit dem die Schieberplatte in der Richtung entlang des Trägerelements (39) des Warenträgers verschiebbar ist.

18. Reflow-Lötanlage gemäß einem der Ansprüche 13-17, **gekennzeichnet durch** eine Steuereinheit zur maschinengesteuerten Vornahme der Einstellung des Warenträgers.

## Claims

1. An article carrier with adjustable support elements for receiving thereon articles of different sizes, in particular for supporting printed circuit boards of different sizes during transport through a reflow soldering system, comprising a frame means (8, 9, 10, 11), especially one frame member of said frame means being used as a support for an article to be carried, and
at least one additional supporting element (16) which is adapted to be adjusted relative to the frame member (11), wherein
arresting means (21, 22) are provided with the aid of which the supporting element (16) can be arrested relative to the frame member (11),
**characterized in that**
the arresting means (21, 22) are adapted to be releasably arrested along guide means (12, 14) comprising at least two rails which extend in the direction of adjustment of the supporting element (16) and along which said supporting element (16) is displaceable, said rails being each fixed to the frame means in parallel, inwards displaced relationship with a frame member (8, 9) and extending through openings (49) in the arresting means (21, 22) for a stepless adjustment of said arresting means along said rails.

2. An article carrier according to claim 1, **characterized in that** the arresting means comprise at least one clamping plate (41, 42), which is articulated on a body (40) and provided with an opening (47) through which a profile of the rail (14) extends at least partially, and respective biasing means (45, 46) with the aid of which the clamping plate(s) articulated on the body (40) is (are) deflected until it (they) abut(s) in the area of the opening (47) on the profile of the rail (14).

3. An article carrier according to claim 2, **characterized in that** the biasing means (45, 46) is a spring resting on the clamping plate (41, 42) on the one hand and on the body (40) on the other.

4. An article carrier according to one of the preceding claims, **characterized in that** an adjustable centre support (18) with arresting means (20, 23) is provided between the frame member (11) and the supporting element (16).

5. An article carrier according to claim 4, **characterized in that** the centre support is provided with a vertically adjustable means (30), which is adapted to be adjusted in a vertical direction that is perpendicular to the plane defined by the support of the frame member (11) and the supporting element (16).

6. An article carrier according to claim 5, **characterized in that** the vertically adjustable means comprises a displaceable plate (30) attached to a support element (39) and provided with guide means along which said displaceable plate is adapted to be displaced in a direction including a vertical component.

7. An article carrier according to claim 6, **characterized in that** the guide means (33, 34) comprise two guide elements which are spaced in the longitudinal direction of the support element (39) and which each form an angle relative to said longitudinal direction of the support element (39), the displaceable plate and the support cooperating via said guide elements so that, in response to a displacement of the displaceable plate (30) in a direction along the support element (39), the displaceable plate will be forced to move in a vertical direction at right angles to the longitudinal dimension of the support element (39).

8. An article carrier according to claim 7, **characterized in that** the guide elements are formed either in the displaceable plate or in the support element, and that the respective other member is provided with studs (35, 36) extending through said guide elements.

9. An article carrier according to claim 8, **characterized in that** the studs are provided with biasing means (37, 38) pressing the displaceable plate against the support element (39).

10. An article carrier according to claim 9, **characterized in that** the biasing means (37, 38) are cup springs.

11. An article carrier according to claims 4 to 10, **characterized in that** an actuating element (32) is provided for vertical adjustment.

12. An article carrier according to one of the preceding claims, **characterized in that** at least the frame member (11) acting as a support is provided with a profile (64, 66) so as to permit the articles to be supported on different levels.

13. A reflow soldering system used for carrying out a reflow soldering process at printed circuit boards provided with electronic components, comprising an article carrier according to one of the preceding claims and an adjustment device used for adapting the adjustable supporting element of the article carrier to the size of the printed circuit boards to be accommodated.

14. A reflow soldering system according to claim 13, **characterized in that** the adjustment device is provided with delocking means which are adapted to be displaced in a direction along which the position of the supporting element can be changed.

15. A reflow soldering system according to claim 13, **characterized in that** the delocking means comprise gripper elements with the aid of which the clamping plates of the arresting means of the article carrier are movable in a direction opposite to the biasing force into contact with the body so as to release a clamping contact of said clamping plates with the profile of the rail.

16. A reflow soldering system according to one of the claims 13 to 15, additionally **characterized by** vertical adjustment means for adjusting a level of the centre support of the article carrier.

17. A reflow soldering system according to claim 16, **characterized in that** the vertical adjustment means comprises a gripper by means of which the displaceable plate can be displaced in the direction along the support element (39) of the article carrier.

18. A reflow soldering system according to one of the claims 13 to 17, **characterized by** a control unit for a machine-controlled execution of the adjustment of the article carrier.

## Revendications

1. Porte-objets à éléments de support réglables pour la réception d'objets de différentes dimensions, en particulier pour le maintien de plaquettes de circuits imprimés de différentes dimensions lors du transport dans un dispositif de soudage par refusion, comprenant un cadre (8, 9, 10, 11), un élément du cadre en particulier servant de surface d'appui pour un objet à porter, et
au moins un autre élément d'appui (16) réglable par rapport à l'élément du cadre (11),
des moyens d'arrêt (21, 22), qui permettent de bloquer l'élément d'appui (16) par rapport à l'élément du cadre (11), étant prévus,
**caractérisé en ce que**
les moyens d'arrêt (21,22) peuvent être bloqués de manière amovible le long de moyens de guidage (12, 14), comprenant au moins deux rails disposés dans la direction de réglage de l'élément d'appui (16), le long desquels l'élément d'appui (16) peut coulisser, les rails étant chacun fixés au cadre parallèlement, décalés vers l'intérieur par rapport à un élément du cadre (8, 9), et traversant les moyens d'arrêt (21, 22), grâce à des alésages (49), pour leur réglage continu le long des rails.

2. Porte-objets selon la revendication 1, **caractérisé en ce que** les moyens d'arrêt comprennent au moins une plaque de serrage (41, 42) articulée sur un élément de base (40) et comprenant un évidement (47) qui est au moins partiellement traversé par un profil du rail (14), et chacun un moyen de précontrainte (45, 46) à l'aide duquel la ou les plaques de serrage articulées sur l'élément de base (40) sont articulées jusqu'à buter sur le profil du rail (14) dans la zone de l'évidement (47).

3. Porte-objets selon la revendication 2, **caractérisé en ce que** le moyen de précontrainte (45, 46) est un ressort prenant appui entre la plaque de serrage (41, 42) et l'élément de base (40).

4. Porte-objets selon l'une quelconque des revendications précédentes, **caractérisé en ce qu'**un support central réglable (18) comprenant des moyens d'arrêt (20, 23) est prévu entre l'élément du cadre (11) et l'élément d'appui (16).

5. Porte-objets selon la revendication 4, **caractérisé en ce que** le support central présente un réglage en hauteur (30) qui est réglable dans le sens de la hauteur qui est perpendiculaire au plan défini par les surfaces d'appui de l'élément du cadre (11) et de l'élément d'appui (16).

6. Porte-objets selon la revendication 5, **caractérisé en ce que** le réglage en hauteur comprend un coulisseau (30), disposé sur un élément support (39), qui possède des moyens de guidage le long desquels le coulisseau peut coulisser selon un vecteur ayant une composante dans le sens de la hauteur.

7. Porte-objets selon la revendication 6, **caractérisé en ce que** les moyens de guidage (33, 34) comprennent deux coulisses espacées dans la longueur de l'élément support (39) et formant chacune un angle par rapport à celle-ci, par l'intermédiaire desquelles le coulisseau et le support interagissent de sorte que, lors du coulissage du coulisseau (30) dans un sens le long de l'élément support (39), le coulisseau se déplace forcément dans le sens de la hauteur perpendiculairement à la longueur de l'élément support (39).

8. Porte-objets selon la revendication 7, **caractérisé en ce que** les coulisses sont réalisées soit dans le coulisseau, soit dans l'élément support et que, dans l'autre partie respective, des broches (35, 36) qui traversent les coulisses sont prévues.

9. Porte-objets selon la revendication 8, **caractérisé en ce que** les broches possèdent des moyens de précontrainte (37, 38) qui pressent le coulisseau contre l'élément support (39).

10. Porte-objets selon la revendication 9, **caractérisé en ce que** les moyens de précontrainte (37, 38) sont des rondelles Belleville.

11. Porte-objets selon les revendications 4 à 10, **caractérisé en ce qu'**un élément de manoeuvre (32) pour le réglage de la hauteur est prévu.

12. Porte-objets selon l'une quelconque des revendications précédentes, **caractérisé en ce qu'**au moins l'élément du cadre (11) servant de surface d'appui présente un profil (64, 66) pour la pose d'objets à différentes hauteurs.

13. Dispositif de soudage par refusion pour la réalisation d'un procédé de soudage par refusion sur des plaquettes de circuits imprimés comportant des composants électroniques, comprenant un porte-objets selon l'une quelconque des revendications précédentes et un dispositif de réglage pour adapter l'élément d'appui réglable du porte-objets à la dimension des plaquettes des circuits imprimés à recevoir.

14. Dispositif de soudage par refusion selon la revendication 13, **caractérisé en ce que** le dispositif de réglage présente des moyens de déblocage pouvant coulisser dans une direction le long de laquelle on peut modifier la position de l'élément d'appui.

15. Dispositif de soudage par refusion selon la revendication 13, **caractérisé en ce que** les moyens de déblocage présentent des éléments de préhension avec lesquels on peut déplacer les plaques de serrage des moyens d'arrêt du porte-objets vers l'élément de base contre la force de précontrainte afin de relâcher une contrainte des plaques de serrage avec le profil des rails.

16. Dispositif de soudage par refusion selon l'une quelconque des revendications 13 à 15, **caractérisé en outre par** un moyen de réglage de la hauteur pour le réglage d'une hauteur du support central du porte-objets.

17. Dispositif de soudage par refusion selon la revendication 16, **caractérisé en ce que** le moyen de réglage de la hauteur comprend un élément de préhension permettant de faire coulisser le coulisseau dans la direction le long de l'élément support (39) du porte-objets.

18. Dispositif de soudage par refusion selon l'une quelconque des revendications 13 à 17, **caractérisé par** une unité de commande pour la réalisation automatisée du réglage du porte-objets.
